# EUROPEAN PATENT SPECIFICATION

(11) **EP 2 472 620 B1**
(45) Date of publication and mention of the grant of the patent: **13.06.2018**
(21) Application number: 10811997.5
(22) Date of filing: 27.08.2010
(51) Int. Cl.: H01L 41/047, H01L 41/083, F02M 51/06

(54) **MULTILAYER PIEZOELECTRIC ELEMENT, AND INJECTION DEVICE AND FUEL INJECTION DEVICE USING THE SAME**
MEHRSCHICHTIGES PIEZOELEKTRISCHES ELEMENT SOWIE INJEKTIONSVORRICHTUNG UND BRENNSTOFFEINSPRITZSYSTEM DAMIT
ÉLÉMENT PIÉZOÉLECTRIQUE STRATIFIÉ AINSI QUE DISPOSITIF D'INJECTION ET SYSTÈME D'INJECTION DE COMBUSTIBLE LE METTANT EN OEUVRE

(30) Priority: 27.08.2009 JP 2009196348
(43) Date of publication of application: 04.07.2012
(73) Proprietor: Kyocera Corporation, Kyoto-shi, Kyoto 612-8501 (JP)
(72) Inventor: HIRA, Takaaki, Kirishima-shi Kagoshima 899-4396 (JP)
(74) Representative: Viering, Jentschura & Partner mbB Patent- und Rechtsanwälte
(86) International application number: PCT/JP2010/064590
(87) International publication number: WO 2011/024948

(56) References cited:
- WO-A1-2009/096381
- JP-A- 11 163 426
- JP-A- 2003 218 416
- JP-A- 2004 266 260
- JP-A- 2004 363 489
- JP-A- 2006 156 587
- JP-A- 2007 134 561
- JP-A- 2008 508 737
- US-A- 5 073 740
- US-A1- 2004 262 037
- US-A1- 2006 061 237
- US-A1- 2006 145 401
- US-A1- 2006 274 042

## Description

The present invention relates to a multi-layer piezoelectric element that can be used as, for example, a piezoelectric driving element (piezoelectric actuator), a pressure sensor element, and a piezoelectric circuit element.

A conventional multi-layer piezoelectric element has, for example, a stacked body in which piezoelectric layers and internal electrode layers are alternately laminated; and a pair of external electrodes which are bonded to side faces of the stacked body so as to make electrical connection with the internal electrode layers that are set so as to have alternately opposite polarities and are led out to the side faces.

In such a multi-layer piezoelectric element, in the interest of increased displacement, it has been customary to design the internal electrode layer so that it is exposed at an end face of the stacked body. Meanwhile, Inside the internal electrode layer generally, voids are included, and the voids are uniformly distributed within a plane of the internal electrode layer.

Besides, the multi-layer piezoelectric element has been required to be adaptable to driving operation at even higher frequencies.

### Citation List

### Patent Literature

Patent Literature 1: Japanese Unexamined Patent Publication JP-A 2006-518934

US 2004/0262037 A1 discloses a multilayer displacement element having internal electrodes with openings therein.

US 5073740 discloses a laminated displacement element where internal electrodes have holes therein.

WO 2009/096381 A1 discloses a laminated piezo element with holes in internal openings.

### Summary of Invention

### Technical Problem

At the time of driving the multi-layer piezoelectric element, an electric field in the internal electrode layer passes along voids existing within the internal electrode layer, wherefore heat tends to be liberated around the voids. Furthermore, in a part of the internal electrode layer more distant from the external electrode, the higher is the frequency of a drive signal, the larger is a lag in the time of energization. Therefore, the driving timing within the plane of the internal electrode layer may be disturbed in the case of high-speed driving operation at a high-frequency pulse. In consequence, during long-time driving operation, the multi-layer piezoelectric element fails to extend straight, and also there arises decline in the amount of displacement due to heat liberated by the multi-layer piezoelectric element.

In addition, in the end face of the internal electrode layer exposed at the side face of the stacked body, the content of moisture trapped in the voids existing in the end face caused migration of metal components constituting the internal electrode layer along the end face of the piezoelectric layer.

This resulted in the difficulty in driving the multi-layer piezoelectric element for a long period of time with stability.

The invention has been devised in view of the problems associated with the conventional art as mentioned supra, and accordingly an object of the invention is to provide a multi-layer piezoelectric element capable of long-time stable and satisfactory driving operation, in which there is no decline in the amount of displacement even under a condition of long-time use, and an end face of an internal electrode layer lying at a side face of a stacked body can be protected against adsorption of the content of moisture and impurities, thereby preventing occurrence of short-circuiting between the internal electrode layers at the side face of the stacked body.

### Solution to Problem

The above problem is solved in that the inventions provides the multi-layer piezoelectric element of claim 1.

Moreover, in the multi-layer piezoelectric element of the invention, it is preferable that the end face of each of the internal electrode layers exposed at the side face of the stacked body is flattened by grinding.

Moreover, in the multi-layer piezoelectric element of the invention, it is preferable that an end part of each of the internal electrode layers exposed at the side face of the stacked body is so shaped as to spread over side faces of an upper piezoelectric layer and a lower piezoelectric layer.

Moreover, the invention provides an injection device according to claim 4, comprising: a container comprising an injection hole; and the multi-layer piezoelectric element mentioned above, wherein a fluid stored in the container is configured to be injected through the injection hole by driving the multi-layer piezoelectric element.

Moreover the invention provides a fuel injection system according to claim 5, comprising: a common rail configured to store a high-pressure fuel; the injection device mentioned above, configured to inject the high-pressure fuel stored in the common rail; a pressure pump configured to supply the high-pressure fuel to the common rail; and an injection control unit configured to send a drive signal to the injection device.

### Advantageous Effects of Invention

According to the multi-layer piezoelectric element of the invention, a multiplicity of voids exists in the internal electrode layers, and the end face of each of the internal electrode layers partly exposed at the side face of the stacked body is substantially free from the voids. That is, since the voids located toward the end face are fewer in number than those located in the inside, it follows that, in the internal electrode layer, an electric field is firstly applied to its periphery (end face), and is whereafter applied to its interior. Therefore, energizations of the individual internal electrode layers at their periphery sides (end-face sides) are timed with one another, which results in coincidences of driving timing within the planes of the individual internal electrode layers. Accordingly, the multi-layer piezoelectric element is able to extend straight even under a condition of long-time use, and is thus resistant to heat liberation. This makes it possible to avoid decline in the amount of displacement.

Moreover, since the end face of each of the internal electrode layers partly exposed at the side face of the stacked body is substantially free from the voids, it is possible to protect the end face of each of the internal electrode layers against adsorption of the content of moisture and impurities, and thereby prevent occurrence of short-circuiting between the internal electrode layers at the side face of the stacked body. Further, since voids exist in the internal electrode layer, it is possible to reduce a stress applied to the internal electrode layer by virtue of the voids, and thereby drive the multi-layer piezoelectric element satisfactorily for a longer period of time with stability, with consequent enhancement of durability.

According to the invention, the injection device comprises: the container comprising an injection hole; and the multi-layer piezoelectric element of the invention, wherein a fluid filled in the container is configured to be injected through the injection hole by driving the multi-layer piezoelectric element. Since the highly durable multi-layer piezoelectric element of the invention is used, the injection device succeeds in providing excellent durability.

According to the invention, the fuel injection system comprises: the common rail configured to store a high-pressure fuel; the injection device of the invention configured to inject the high-pressure fuel stored in the common rail; the pressure pump configured to supply the high-pressure fuel to the common rail; and the injection control unit configured to send a drive signal to the injection device. Since the injection device of the invention incorporating the highly durable multi-layer piezoelectric element of the invention is used, the fuel injection system succeeds in providing excellent durability.

### Brief Description of Drawings

Fig. 1 is a perspective view showing an example of a multi-layer piezoelectric element according to an embodiment of the invention;
Fig. 2 is a sectional view of the multi-layer piezoelectric element shown in Fig. 1 taken along a section parallel to a stacked direction of a stacked body, illustrating a part including internal electrode layers each having an exposed end face;
Fig. 3 is a sectional view of the multi-layer piezoelectric element shown in Fig. 1 taken along a section parallel to the stacked direction of the stacked body, illustrating a part including the internal electrode layers having an exposed end face;
Fig. 4 is a schematic sectional view showing an example of an injection device according to an embodiment of the invention; and
Fig. 5 is a schematic block diagram showing an example of a fuel injection system according to an embodiment of the invention.

### Description of Embodiments

Hereinafter, examples of a multi-layer piezoelectric element according to an embodiment of the invention will be described in detail with reference to the drawings.

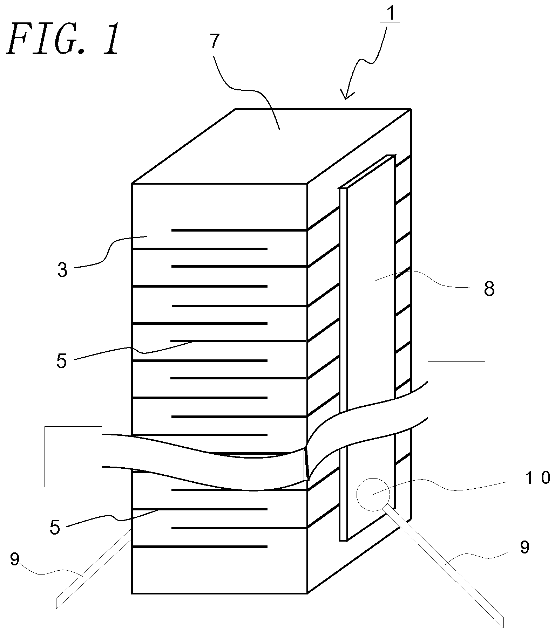

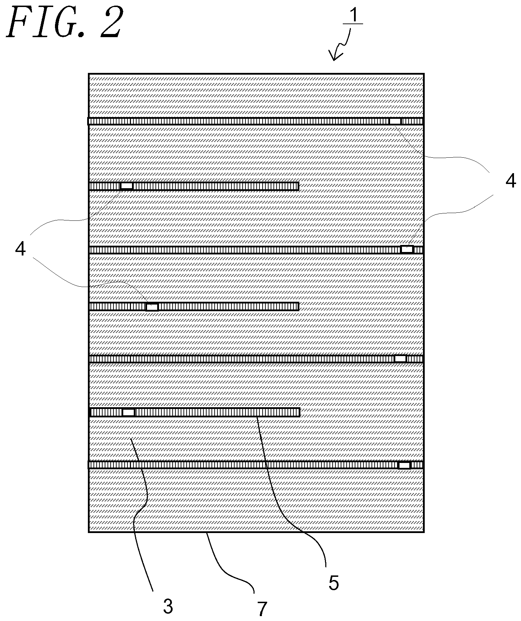

Fig. 1 is a perspective view showing an example of a multi-layer piezoelectric element according to an embodiment of the invention. Fig. 2 is a sectional view of the multi-layer piezoelectric element shown in Fig. 1 taken along a section parallel to a stacked direction of a stacked body, illustrating a part including internal electrode layers each having an exposed end face. As shown in Figs. 1 and 2, the multi-layer piezoelectric element 1 of this embodiment comprises a stacked body 7 in which piezoelectric layers 3 and internal electrode layers 5 are alternately laminated in such a way that an end face of each of the internal electrode layers 5 is partly exposed at a side face of the stacked body 7. Moreover, external electrodes 8, taken as a pair, are bonded to the side faces, respectively, of the stacked body 7 so as to make connection with the internal electrode layers 5. At this time, while a multiplicity of voids 4 exists in the internal electrode layers 5, the end face of each of the internal electrode layers partly exposed at the side face of the stacked body 7 is substantially free from the voids 4.

The piezoelectric layer 3 constituting the stacked body 7 is made of piezoelectric ceramics having piezoelectric characteristics such for example as a perovskite-type oxide of PbZrO₃-PbTiO₃ (PZT: lead zirconate titanate). Moreover, the internal electrode layers 5 are alternately laminated together with the piezoelectric layers 3 in such a way that the piezoelectric layer 3 is sandwiched between upper and lower internal electrode layers 5. In this way, positive electrodes and negative electrodes are arranged in an orderly sequence in the stacked direction, so that a driving voltage can be applied to the piezoelectric layer 3 sandwiched between the electrodes. The internal electrode layer 5 is made of a metal such for example as silver-palladium (Ag-Pd). In this embodiment, positive electrodes and negative electrodes (or grounding electrodes) are led out to the opposed side faces, respectively, of the stacked body 7 in a staggered arrangement, with their end faces partly exposed for electrical connection with the paired external electrodes 8 each bonded to the side face of the stacked body 7.

Furthermore, a portion between the piezoelectric layers 3 of the stacked body 7 partially has the stress relaxing layer (not shown) instead of the internal electrode layer 5. The stress relaxing layer has a strength lower than that of the internal electrode layer 5 and is easily cracked by stress. Thus, stress generated in the stacked body 7 by driving operation causes damage such as cracks forming sooner in the stress relaxing layer than in the internal electrode layer 5. That is to say, the stress relaxing layers function as stress relaxing layers in the stacked body 7.

In the multi-layer piezoelectric element 1 of the invention, as shown in Fig. 2, the voids 4 exist in the internal electrode layer 5, and the end face of each of the internal electrode layers 5 partly exposed at the side face of the stacked body 7 is substantially free from the voids 4 (the voids are not observed), and the voids 4 are not exposed at the end face of each of the internal electrode layers 5.

In the case where the voids 4 are not exposed at the end face of each of the internal electrode layers 5 exposed at the side face of the stacked body 7, expressed differently, are substantially nonexistent (not observed), in the internal electrode layer 5, an electric field induced by the driving voltage applied to the internal electrode layer 5 through the external electrode 8 is firstly applied to its periphery (end face), and is whereafter applied to its interior. Therefore, energizations of the individual internal electrode layers 5 at their periphery sides (end-face sides) are timed with one another, which results in coincidences of driving timing within the planes of the individual internal electrode layers 5. Accordingly, the multi-layer piezoelectric element 1 is able to extend straight even under a condition of long-time use, and is thus resistant to heat liberation. Since the piezoelectric layer 3, whose displacement is temperature-dependent, is not heated, it follows that the multi-layer piezoelectric element 1 can be driven to operate with stability. Moreover, since the voids 4 are substantially nonexistent and are thus not exposed at the exposed end face of each of the internal electrode layers 5, it is possible to protect the exposed end face of each of the internal electrode layers 5 against adsorption of the content of moisture and impurities, and thereby prevent occurrence of migration of metal components between the internal electrode layers 5. Further, since a multiplicity of voids 4 exists in the internal electrode layers 5, it is possible to effectively relax a stress which is applied to the internal electrode layer 5 in the course of driving operation.

In the interior of the stacked body 7, a multiplicity of voids 4 existing in the internal electrode layers 5 ranges in size from 0.1 µm to 5 µm in diameter, and is scattered overall at a porosity in a range of 5% to 40%. As used herein, the term "porosity" refers to the proportion in area of the voids 4 in the cross section of the internal electrode layer 5 in a direction perpendicular to the stacked direction. The porosity of the interior of the internal electrode layer 5 can be adjusted to a desired level in accordance with the following production technique. Specifically, substances that disappear or are released during firing, for example, resin powder such as acrylic beads or carbon powder, are admixed in an internal electrode layer conductive paste that is shaped into the internal electrode layer 5. This allows formation of the internal electrode layer 5 in which a multiplicity of voids 4 exists at a desired porosity.

In the multi-layer piezoelectric element 1 of the invention, it is preferable that the end face of each of the internal electrode layers 5 exposed at the side face of the stacked body 7 is flattened by grinding. This makes it possible to ensure that the end face of each of the internal electrode layers 5 exposed at the side face of the stacked body 7 is substantially free from the voids 4. In addition, since the end face has an even surface after the flattening operation, it is possible to achieve uniform concentration of the electric field from the end face of each of the internal electrode layers 5 to the outer side, and thereby prevent occurrence of electrical discharge due to localized concentration of the electric field.

The surface flattening operation by grinding for the end face of each of the internal electrode layers 5 is carried out as follows. The first step is to perform grinding on the end face of each of the internal electrode layers 5 exposed at the side face of the stacked body 7 in a direction parallel to the internal electrode layer 5. After that, the surface of the end face is ground, with the depth of cut set at a low (or zero). In this way, the end face of each of the internal electrode layers 5, being higher in softness than the piezoelectric layer 3, is abrasively machined by an abrasive stone, thereby causing that part of the end face which is exposed at the side face of the stacked body 7 to become deformed so as to fill in the voids 4. As a result, there is obtained the stacked body 7 with the internal electrode layer 5 having a flattened end face which is exposed at the side face of the stacked body 7 and is substantially free from the voids 4. As used herein, the expression "the exposed end face of each of the internal electrode layers 5 is substantially free from the voids 4" refers to the condition that, when the end face of each of the internal electrode layers 5 is observed by a metallurgical microscope or SEM (scanning-type microscope), between crystalline particles constituting the internal electrode layer 5 is found a difference in level greater than the diameter of a crystalline particle resulting from the grinding, yet it is recognized that there exists no pore through which a crystalline particle lying inside the crystalline particles constituting the end part of the internal electrode layer 5 can be observed. In other words, a pore through which the inlying crystalline particle can be observed is defined as the void, whereas a pore through which no inlying crystalline particle is observed is not construed as the void.

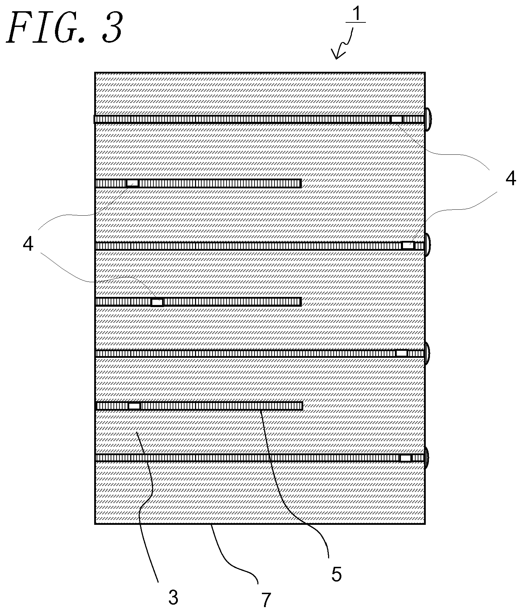

Next, Fig. 3 is a sectional view of the multi-layer piezoelectric element 1 shown in Fig. 1 taken along a section parallel to the stacked direction of the stacked body 7, illustrating a part including the internal electrode layers 5 having an exposed end face. In the multi-layer piezoelectric element 1 of the invention, as shown in Fig. 3, the end part of the internal electrode layer 5 exposed at the side face of the stacked body 7 should preferably be so shaped as to spread over side faces of, respectively, an upper piezoelectric layer 3 and a lower piezoelectric layer 3. In the case where the end part of each of the internal electrode layers 5 is so shaped as to spread over the side faces of the upper and lower piezoelectric layers 3 on the side face of the stacked body 7, the end part has a so-called nail-headed cross-sectional configuration. This makes it possible to restrain development of a gap between the internal electrode layer 5 and the piezoelectric layer 3 on the side face of the stacked body 7, and thereby provide excellent sealability for the side face of the stacked body 7 where the end face of each of the internal electrode layers 5 is exposed, as is desirable.

The end part of each of the internal electrode layers 5 spreading over the side faces of the upper and lower piezoelectric layers 3 can be formed as follows. The first step is to perform selective grinding in a manner that the piezoelectric layer 3 is ground as appropriate, whereas the internal electrode layer 5 is ground little. Specifically, grinding is performed on the side face of the stacked body 7 in a direction parallel to the internal electrode layer 5 by a wire saw using flowable abrasive grains. In this way, the stacked body 7 can be processed into a form in which the end part of the internal electrode layer 5 protrudes from the side face of the piezoelectric layer 3. After that, in the manner as above described, the side face of the stacked body 7 is abrasively machined in the direction parallel to the internal electrode layer 5 for a plurality of times (preferably three or more times) by a surface grinder or polygon processing machine. At this time, the depth of cut for the honing is set at a low, preferably 50 µm or less, more preferably 5 µm or less. As a result, the end part of each of the internal electrode layers 5 protruding from the side face of the piezoelectric layer 3 is crushed from above downward to become deformed so as to spread over the side faces of the upper and lower piezoelectric layers 3.

Next, an example of a method for manufacturing the multi-layer piezoelectric element 1 of this example will be described.

To begin with, piezoelectric ceramic green sheets for constituting the piezoelectric layers 3 are produced. Specifically, calcined powder of piezoelectric ceramics, a binder made of an organic high polymer such as acrylic polymer or butyral polymer, and a plasticizer are mixed to prepare a ceramic slurry. The ceramic slurry is shaped into piezoelectric ceramic green sheets by a tape casting method such as the doctor blade method or the calender roll method. The piezoelectric ceramics may be of any given type so long as it has piezoelectric property. For example, a perovskite-type oxide made of lead zirconate titanate (PZT: PbZrO₃-PbTiO₃) can be used. Moreover, as the plasticizer, dibutyl phthalate (DBP), dioctyl phthalate (DOP), or the like can be used.

Then, an internal electrode layer conductive paste that is shaped into the internal electrode layer 5 is produced. Specifically, the internal electrode layer conductive paste is prepared by admixing a binder and a plasticizer in metal powder of, for example, a silver-palladium (Ag-Pd) alloy. Note that a mixture of silver powder and palladium powder may be used instead of the silver-palladium alloy.

In order to form a multiplicity of voids 4 in the internal electrode layers 5 effectively, it is desirable to mix substances that disappear or are released during firing, such for example as acrylic beads, in the internal electrode layer conductive paste. Following the completion of firing, areas of the paste which bore acrylic beads become the voids 4 that exist in the internal electrode layer 5.

Then, the internal electrode layer conductive paste is applied, in a specific pattern of the internal electrode layer 5, onto the piezoelectric ceramic green sheets by means of screen printing, for example.

Moreover, a stress relaxing layer paste is applied, in a specific pattern of the stress relaxing layer, onto other piezoelectric ceramic green sheets by means of screen printing. The pattern of the stress relaxing layer may be designed either as a whole pattern extending over the range of the entire cross section of the stacked body 7 perpendicular to the stacked direction, or as a partial pattern. Preferably, the paste is printed in a partial pattern with a non-formed region where the stress relaxing layer is not formed, rather than a whole pattern. Moreover, in the interest of preventing occurrence of short-circuiting between the paired external electrodes 8 without fail, it is desirable to adopt a pattern such that the non-formed region acts as partition between the positive and negative external electrodes 8.

Then, a predetermined number of the piezoelectric ceramic green sheets with coatings of the internal electrode layer conductive paste are laminated on top of each other. At this time, the piezoelectric ceramic green sheets with coatings of the stress relaxing layer paste are laminated at predetermined spacing (intervals of a predetermined number of the piezoelectric ceramic green sheets). Moreover, it is possible to laminate a conductive paste-free piezoelectric ceramic green sheet on each of the top and the bottom of the resultant layered body as opposite end parts.

Furthermore, after debinding treatment at a predetermined temperature, firing is performed at 900°C to 1200°C to form a stacked body 7 in which piezoelectric layers 3 and internal electrode layers 5 are alternately laminated and a stress relaxing layer is disposed at part of the portions between the piezoelectric layers 3.

Next, the side face of the stacked body 7 obtained by firing is abrasively machined to ensure that the end face of each of the internal electrode layers 5 exposed at the side face is substantially free from the voids 4. Specifically, the side face of the stacked body 7, at which is exposed the end face of each of the internal electrode layers 5, is ground in the direction parallel to the internal electrode layer 5 until the stacked body 7 is turned into a predetermined shape by a surface grinder or polygon processing machine using abrasive stones ranging in count from #200 to #1000, for example. Then, after the depth of cut is reduced to a low, preferably 50 µm or below, more preferably 5 µm or below, the side face is further abrasively machined for a plurality of times (preferably three or more times). Thereby, only the internal electrode layer 5 which is softer than the piezoelectric layer 3 is plastically, or ductilly deformed by the honing so as to fill in the void 4 exposed at the end face. This makes it possible to ensure that the end face of each of the internal electrode layers 5 exposed at the side face of the stacked body 7 is substantially free from the voids 4.

Further, as shown in Fig. 3, the end part of each of the internal electrode layers 5 exposed at the side face of the stacked body 7 is shaped so as to spread over the side faces of the upper and lower piezoelectric layers 3 in the following manner. That is, the stacked body 7 obtained by firing is subjected to selective grinding so that the piezoelectric layer 3 is ground as appropriate, whereas the internal electrode layer 5 is ground little. Specifically, the side face of the stacked body 7 is ground in the direction parallel to the internal electrode layer 5 by a wire saw using flowable abrasive grains. In this way, the stacked body 7 can be processed into a form in which the end part of the internal electrode layer 5 protrudes from the side face of the piezoelectric layer 3. After that, in the manner as above described, the side face of the stacked body 7 is abrasively machined in the direction parallel to the internal electrode layer 5 for a plurality of times (preferably three or more times) by a surface grinder or polygon processing machine. At this time, the depth of cut for the honing is set at a low, preferably 50 µm or less, more preferably 5 µm or less. As a result, the end part of each of the internal electrode layers 5 protruding from the side face of the piezoelectric layer 3 is crushed from above downward so as to spread over the side faces of the upper and lower piezoelectric layers 3.

Subsequently, a silver-glass conductive paste which is composed predominantly of silver and contains glass is printed, in a specific pattern of the external electrode 8, onto the side face of the stacked body 7 where the internal electrode layer 5 is led out. Then, baking treatment is performed thereon at a temperature in a range of 650°C to 750°C. In this way, the external electrode 8 is formed.

Then, an external lead member 9 is fixedly connected to the surface of the external electrode 8 via a conductive bonding material (solder) 10.

After that, a direct-current electric field of 0.1 to 3 kV/mm is applied, through the external electrodes 8 and the internal electrode layer 5, to the piezoelectric layer 3 from the external lead member 9 connected to each of the paired external electrodes 8 to initiate polarization in the piezoelectric layer 3 constituting the stacked body 7. In this way, the construction of the multi-layer piezoelectric element 1 is completed. In this multi-layer piezoelectric element 1, the external electrode 8 and an external power source are connected to each other via the external lead member 9, so that a driving voltage can be applied to the piezoelectric layer 3 via the internal electrode layers 5. This allows each of the piezoelectric layers 3 to undergo significant displacement under an inverse piezoelectric effect. Thus, the multi-layer piezoelectric element is capable of functioning as, for example, an automotive fuel injection valve for the injection supply of fuel to an engine.

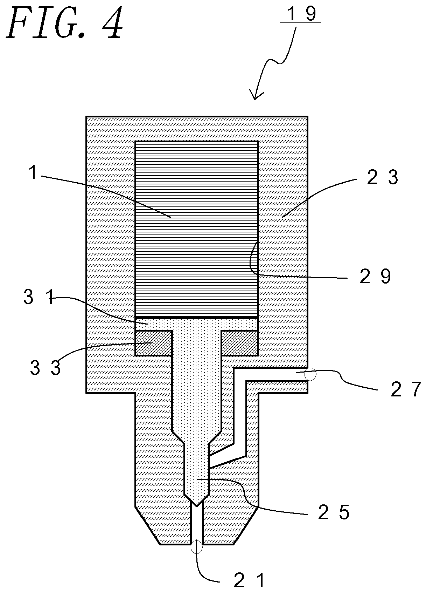

Next, an example of an injection device according to an embodiment of the invention will be described. Fig. 4 is a schematic cross-sectional view showing an example of an injection device according to an embodiment of the invention.

As shown in Fig. 4, an injection device 19 of this example comprises a housing (container) 23 comprising an injection hole 21 at one end thereof, and the foregoing multi-layer piezoelectric element 1 of the example placed within the housing 23.

In an interior of the housing 23 is disposed a needle valve 25 capable of opening and closing of the injection hole 21. A fluid passage 27 is so disposed as to be capable of communicating with the injection hole 21 in accordance with the movement of the needle valve 25. The fluid passage 27 is coupled to an external fluid supply source, so that a fluid is supplied to the fluid passage 27 under high pressure at all times. Therefore, when the needle valve 25 is operated to open the injection hole 21, then a fluid which has been fed through the fluid passage 27 is injected, through the injection hole 21, to an exterior of the device or into an adjacent container, for example, a fuel chamber of an internal-combustion engine (not shown).

Furthermore, an upper end of the needle valve 25 is a piston 31 having an inner diameter larger than that of the other portions, and this piston 31 slides along the inner wall 29 of the cylindrical housing 23. Furthermore, the foregoing multi-layer piezoelectric element 1 of the invention is placed within the housing 23.

In the injection device 19, upon extension of the multi-layer piezoelectric element 1 entailed by application of voltage, the piston 31 is pushed forward, thus causing the needle valve 25 to close the fluid passage 27 communicating with the injection hole 21 with a consequent halt on supply of fluid. Moreover, upon stopping the application of voltage, the multi-layer piezoelectric element 1 is contracted, and a disc spring 33 pushes the piston 31 backward, thereby opening the fluid passage 27. In consequence, the injection hole 21 communicates with the fluid passage 27 so that injection of fluid can be carried out through the injection hole 21.

It is noted that the injection device may be so designed that the fluid passage 27 is opened by applying a voltage to the multi-layer piezoelectric element 1, and is contrariwise closed upon a halt on the application of voltage.

Moreover, the injection device of the example may comprise a container 23 comprising an injection hole 21 and the multi-layer piezoelectric element 1 according to the example, wherein a fluid stored in the container is configured to be injected through the injection hole by driving the multi-layer piezoelectric element 1. That is, the multi-layer piezoelectric element 1 does not necessarily have to be placed within the housing 23. It is essential only that a pressure for control of fluid injection is applied to the interior of the housing by driving the multi-layer piezoelectric element 1. In the injection device 19 of this example, the term "fluid" is construed as encompassing not only fuel and ink, but also various liquid fluid such as a conductive paste, and gases. The use of the injection device 19 of the example makes it possible to control a flow rate of fluid and timing of fluid injection with stability for a long period of time.

When the injection device 19 of this example using the multi-layer piezoelectric element 1 of this example is used for an internal-combustion engine, fuel can be injected toward a combustion chamber of the internal-combustion engine such as an engine with higher accuracy for a longer period of time compared to the case of using a conventional injection device.

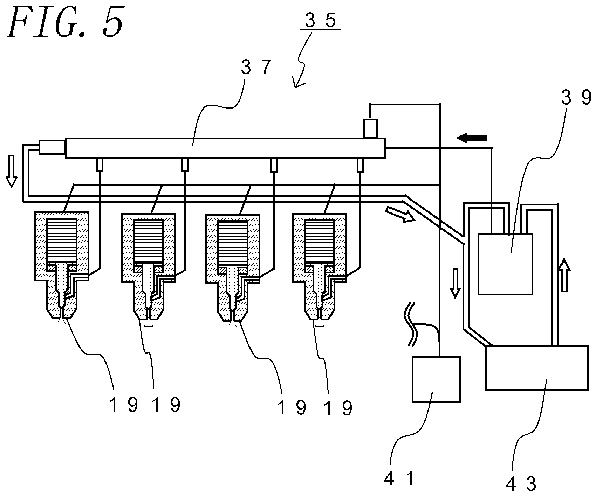

Next, an example of a fuel injection system according to an embodiment of the invention will be described. Fig. 5 is a schematic view showing an example of a fuel injection system according to an embodiment of the invention.

As shown in Fig. 5, the fuel injection system 35 of the example comprises a common rail 37 configured to store a high-pressure fuel as a high-pressure fluid, a plurality of the injection devices 19 of the example configured to inject the high-pressure fluid stored in the common rail 37, a pressure pump 39 configured to supply the high-pressure fluid to the common rail 37, and an injection control unit 41 configured to send a drive signal to the injection devices 19.

The injection control unit 41 controls an amount of injection of the high-pressure fluid and timing of fluid injection on the basis of external information or external signals. For example, in the case of using the fuel injection system 35 for injection of fuel into an engine, it is possible to control the amount of fuel injection and the timing of fuel injection while detecting the condition of the interior of the combustion chamber of the engine by a sensor or the like. The pressure pump 39 plays a role of supplying a fluid fuel from a fuel tank 43 to the common rail 37 under high pressure. For example, in the fuel injection system 35 for use in engine application, the fluid fuel is fed to the common rail 37 under high pressure of about 1000 to 2000 atmospheres (about 101 MPa to about 203 MPa), and preferably high pressure of about 1500 to 1700 atmospheres (about 152 MPa to about 172 MPa). The common rail 37 stores therein the high-pressure fuel from the pressure pump 39 and acts to feed it to the injection device 19 on an as needed basis. As has already been described, the injection device 19 injects fluid in a certain amount to the exterior of the device or into an adjacent container through the injection hole 21. For example, in the case where an engine is a target of fuel supply by injection, high-pressure fuel in fine-spray form is injected into the combustion chamber of the engine through the injection hole 21.

It is to be understood that the application of the invention is not limited to the specific embodiments described heretofore, and that various changes and modifications can be made without departing from the scope of the invention defined by the claims. For example, although two external electrodes 8 in the multi-layer piezoelectric element 1 are respectively formed on two opposing side faces of the stacked body 7 in the above-described example, two external electrodes 8 may be formed on adjacent side faces of the stacked body 7 or may be formed on the same side face of the stacked body 7. Furthermore, while, in the foregoing examples, the stacked body 7 has a rectangular sectional profile as viewed in a direction perpendicular to the stacked direction, the sectional profile may be defined by a polygon such as a hexagon or octagon, a circle, or a combination of a straight line and an arc, instead.

For example, the multi-layer piezoelectric element 1 of the example is used for a piezoelectric driving element (piezoelectric actuator), a pressure sensor element, a piezoelectric circuit element, and so forth. Examples of the driving element include a fuel injection device for an automotive engine, a liquid injection device such as an ink-jet system, a precise positioning device such as an optical device, and an anti-vibration device. Examples of the sensor element include a combustion pressure sensor, a knocking sensor, an acceleration sensor, a load sensor, an ultrasound sensor, a pressure-sensing element, and a yaw-rate sensor. Examples of the circuit element include a piezoelectric gyroscope, a piezoelectric switch, a piezoelectric transformer, and a piezoelectric breaker.

### Examples

Hereinafter, an example of the multi-layer piezoelectric element of the invention will be described.

A piezoelectric actuator comprising the multi-layer piezoelectric element of the invention was fabricated as follows. Firstly, a ceramic slurry was prepared by mixing calcined powder of piezoelectric ceramics composed predominantly of lead zirconate titanate (PZT: PbZrO₃-PbTiO₃) having an average particle size of 0.4 µm, a binder, and a plasticizer. The ceramic slurry was shaped into piezoelectric ceramic green sheets having a thickness of 100 µm for forming piezoelectric layers by the doctor blade method. After that, an internal electrode layer conductive paste was prepared by adding a plasticizer and a binder to a mixture composed of silver-palladium alloy powder blended with acrylic beads in an amount of 20% by mass relative to the sum total of the silver-palladium alloy.

Then, the internal electrode layer conductive paste was applied onto the piezoelectric ceramic green sheets by means of screen printing, and 300 pieces of these sheets were laminated on top of each other.

The resultant was fired at a temperature in a range of 980°C to 1100°C, whereupon a stacked body was obtained.

Next, the stacked body obtained by firing was ground into a predetermined shape by an abrasive stone with a count of #600, with the depth of cut set at 100 µm. Then, the side face of the stacked body was abrasively machined 10 times, with the depth of cut changed to 0 µm.

In this way, there was obtained the stacked body in which a multiplicity of voids exists in the internal electrode layers and the end face of each of the internal electrode layer partly exposed at the side face of the stacked body is substantially free from the voids.

Next, the side face of the stacked body in finished form was polished to a mirror-smooth state, and then the internal electrode layer, part of which is exposed at the side face of the stacked body, was examined to check the presence or absence of voids. The result showed that a multiplicity of voids, the average size of which was 3 µm, were substantially evenly distributed inside the internal electrode layer in a proportion of 20% by volume on average, but no voids were observed in the end part of the internal electrode layer exposed at the side face of the stacked body. At this time, the exposed end face of each of the internal electrode layers was flattened as the result of grinding.

Subsequently, a silver-glass paste prepared by adding glass, a binder, and a plasticizer to silver powder was printed, in a specific pattern of the external electrode, onto the side face of the stacked body, followed by baking treatment at 700°C. In this way, there was formed the external electrode connected to the internal electrode layer. Then, as an external lead member, a lead wire was fixedly connected to the external electrode with use of solder as a conductive bonding material. In the manner as above described, the example of the multi-layer piezoelectric element of the invention (Sample number 1) was fabricated.

On the other hand, by way of a comparative example, there was fabricated a sample in which the stacked body obtained by firing was ground into a predetermined shape by an abrasive stone with a count of #600, with the depth of cut set at 100 µm. Likewise, in this sample, the side face of the stacked body was polished to a mirror-smooth state, and then the internal electrode layer, part of which was exposed at the side face of the stacked body, was examined to check the presence or absence of voids. The result showed that a multiplicity of voids, the average size of which was 3 µm, were substantially evenly distributed inside the internal electrode layer in a proportion of 20% by volume on average, and similarly a multiplicity of voids of the same average size was substantially evenly distributed, in a proportion of 20% by volume on average, even in the end part of the internal electrode layer exposed at the side face of the stacked body.

Subsequently, based on the sample for the comparative example, there was fabricated a stacked body, the side face of which where the end face of each of the internal electrode layers was exposed was abrasively machined by a surface grinder, so that a multiplicity of voids was exposed at the end face of each of the internal electrode layers. The side face of the stacked body thus obtained was then coated with silicone resin. In this way, the comparative example of the multi-layer piezoelectric element (Sample number 2) was fabricated.

Next, polarizing treatment on the piezoelectric layers was performed in which a direct-current electric field of 3 kV/mm was applied for 15 minutes via the outer lead members to the external electrodes of the multi-layer piezoelectric elements of Sample numbers 1 and 2.

An alternating-current voltage of 0 V to +160 V was applied to the multi-layer piezoelectric elements of Sample numbers 1 and 2 in an atmosphere of 150°C and at a frequency of 150 Hz, and a durability test that performed continuous driving opeariton 1 × 10⁸ times was carried out. Table 1 shows the obtained results.

**Table 1**

| Sample number | Durability test result |
|---|---|
| 1 | No problem occurred after 1 × 10^8 cycles of driving operation |
| 2 | External electrode peeled off stacked body that resulted in sparking after 2 × 10^7 cycles of driving operation |

As shown in Fig. 1, in the multi-layer piezoelectric element implemented by way of the example of the invention (Sample number 1), even after 1 × 10⁸ cycles of continuous driving operation, there was no sign of abnormality. This is because, since the exposed end face of each of the internal electrode layers is substantially free from the voids and thus voids located outward are few in number, it followed that, in the internal electrode layer, an electric field is applied firstly to its periphery, and is whereafter applied to its interior for energization. Therefore, energizations of the individual internal electrode layers at their peripheral sides are timed with one another, which resulted in coincidences of driving timing within the planes parallel to the internal electrode layers. As a result, the stacked body is able to extend straight even under a long-time driving operation, and the multi-layer piezoelectric element becomes resistant to heat liberation. This makes it possible to avoid decline in the amount of displacement.

Moreover, since the number of voids in the end face, or the peripheral side of the internal electrode layer is reduced, it becomes possible to protect the end face against adsorption of the content of moisture and impurities, and thereby prevent occurrence of short-circuiting between the internal electrode layers at the side face of the stacked body. Meanwhile, since a multiplicity of voids exists inside the internal electrode layers, a stress applied to the internal electrode layer can be relaxed, with consequent enhancement of durability. Further, since localized concentration of the electric field at part of the end face of each of the internal electrode layers can be restrained for prevention of occurrence of electrical discharge, it becomes possible to provide excellent sealability for the end face of each of the internal electrode layers.

On the other hand, in the multi-layer piezoelectric element implemented by way of the comparative example (Sample number 2), after 2 × 10⁶ cycles of continuous driving operation, the external electrode peels off the stacked body that resulted in sparking, and eventually the operation of the multi-layer piezoelectric element is interrupted.

### Reference Signs List

- 1:: Multi-layer piezoelectric element
- 3:: Piezoelectric layer
- 4:: Void
- 5:: Internal electrode layer
- 7:: Stacked body
- 8:: External electrode
- 9:: External lead member
- 19:: Injection device
- 21:: Injection hole
- 23:: Housing (Container)
- 25:: Needle valve
- 27:: Fluid passage
- 29:: Cylinder
- 31:: Piston
- 33:: Disc spring
- 35:: Fuel injection system
- 37:: Common rail
- 39:: Pressure pump
- 41:: Injection control unit
- 43:: Fuel tank

## Claims

1. A multi-layer piezoelectric element, comprising:
a stacked body (7) in which piezoelectric layers (3) and internal electrode layers (5) are alternately laminated, an end face of each of the internal electrode layers (5) being partly exposed at a side face of the stacked body (7); and
a pair of external electrodes (8) bonded to the partly exposed end face of each of the internal electrode layers (5),
**characterized in that**
a multiplicity of voids (4) existing in each of the internal electrode layers (5) ranges in size from 0.1 µm to 5 µm in diameter, and is scattered overall at a porosity in a range of 5% to 40%, wherein the porosity is a proportion in area of the voids in a cross section of the internal electrode layer in a direction perpendicular to a stacked direction of the stacked body, and
the partly exposed end face of each of the internal electrode layers (5) is substantially free from the voids (4) .

2. The multi-layer piezoelectric element according to claim 1, wherein the partly exposed end faces of the internal electrode layers (5) are flattened.

3. The multi-layer piezoelectric element according to claim 1, wherein an end part of each of the internal electrode layers (5) spreads over side faces of an upper piezoelectric layer and of a lower piezoelectric layer, said end part bearing the partly exposed end face.

4. An injection device, comprising:
a container comprising an injection hole; and
the multi-layer piezoelectric element according to any one of claims 1 to 3, wherein
a fluid stored in the container is configured to be injected through the injection hole by driving the multi-layer piezoelectric element.

5. A fuel injection system, comprising:
a common rail configured to store a high-pressure fuel;
the injection device according to claim 4, configured to inject the high-pressure fuel stored in the common rail;
a pressure pump configured to supply the high-pressure fuel to the common rail; and
an injection control unit configured to send a drive signal to the injection device.

## Patentansprüche

1. Ein Mehrschicht- piezoelektrisches Element, aufweisend:
einen Stapelkörper (7), in dem piezoelektrische Schichten (3) und innere Elektrodenschichten (5) abwechselnd laminiert sind, wobei eine Endfläche von jeder der inneren Elektrodenschichten (5) an einer Seitenfläche des Stapelkörpers (7) teilweise freigelegt ist, und
ein Paar äußerer Elektroden (8), die mit der teilweise freigelegten Endfläche von jeder der inneren Elektrodenschichten (5) verbunden sind,
**dadurch gekennzeichnet, dass**
eine Mehrzahl von Lücken (4), die in jeder der inneren Elektrodenschichten (5) vorhanden sind, eine Durchmessergröße von 0,1 µm bis 5 µm haben und insgesamt mit einer Porosität in einem Bereich von 5% bis 40% verstreut ist, wobei die Porosität ein Flächenanteil der Lücken in einem Querschnitt der inneren Elektrodenschicht in einer Richtung senkrecht zu einer Stapelrichtung des Stapelkörpers ist, und
die teilweise freigelegte Endfläche von jeder der inneren Elektrodenschichten (5) im Wesentlichen frei von den Lücken (4) ist.

2. Das Mehrschicht- piezoelektrische Element gemäß Anspruch 1, wobei die teilweise freigelegten Endflächen der inneren Elektrodenschichten (5) abgeflacht sind.

3. Das Mehrschicht- piezoelektrische Element gemäß Anspruch 1, wobei sich ein Endteil von jeder der inneren Elektrodenschichten (5) über Seitenflächen einer oberen piezoelektrischen Schicht und einer unteren piezoelektrischen Schicht verteilt, wobei der Endteil die teilweise freigelegte Endfläche trägt.

4. Eine Einspritzvorrichtung, aufweisend:
einen Behälter, der ein Einspritzloch aufweist, und
das Mehrschicht- piezoelektrische Element gemäß irgendeinem der Ansprüche 1 bis 3, wobei
ein in dem Behälter gespeichertes Fluid konfiguriert ist, um durch Antreiben/Ansteuern des Mehrschichtpiezoelektrischen Elements durch das Einspritzloch hindurch eingespritzt zu werden.

5. Ein Kraftstoff-Einspritzsystem, aufweisend:
einen Common Rail, der konfiguriert ist, um einen Hochdruck-Kraftstoff zu speichern,
die Einspritzvorrichtung gemäß Anspruch 4, die konfiguriert ist, um den in dem Common Rail gespeicherten Hochdruck-Kraftstoff einzuspritzen,
eine Druckpumpe, die konfiguriert ist, um den Hochdruck-Kraftstoff dem Common Rail zuzuführen, und
eine Einspritz-Steuereinheit, die konfiguriert ist, um der Einspritzvorrichtung ein Antriebs- /Ansteuersignal zu senden.

## Revendications

1. Un élément piézoélectrique multicouche, comportant :
un corps empilé (7) dans lequel des couches piézoélectriques (3) et des couches d'électrodes internes (5) sont laminées en alternance, une face terminale de chacune des couches d'électrodes internes (5) étant exposée en partie à une face latérale du corps empilé (7), et
une paire d'électrodes externes (8) reliées à la face terminale exposée en partie de chacune des couches d'électrodes internes (5)
**caractérisé en ce que**
une multiplicité de vides (4) existant dans chacune des couches d'électrodes externes (5) s'étend dans une taille de diamètre de 0,1 µm à 5 µm et est éparpillée dans l'ensemble avec une porosité dans une gamme de 5% à 40%, la porosité étant une proportion de la surface des vides en section transversale de la couche d'électrodes internes dans une direction perpendiculaire à une direction d'empilement du corps empilé, et
la face terminale exposée en partie de chacune des couches d'électrodes internes (5) est essentiellement sans vides (4).

2. L'élément piézoélectrique multicouche selon la revendication 1, dans lequel les faces terminales exposées en partie des couches d'électrodes internes (5) sont aplaties.

3. L'élément piézoélectrique multicouche selon la revendication 1, dans lequel une partie terminale de chacune des couches d'électrodes internes (5) se répand sur des faces latérales d'une couche piézoélectrique supérieure et d'une couche piézoélectrique inférieure, ladite partie terminale portant la face terminale exposée en partie.

4. Un dispositif d'injection, comportant :
un récipient comprenant un trou d'injection, et
l'élément piézoélectrique multicouche selon l'une quelconque des revendications 1 à 3, dans lequel
un fluide stocké dans le récipient est configuré de manière à être injecté à travers le trou d'injection en entraînant l'élément piézoélectrique multicouche.

5. Un système d'injection de carburant, comportant :
une rampe commune configurée de manière à stocker un carburant à haute pression,
le dispositif d'injection selon la revendication 4, configuré de manière à injecter le carburant à haute pression stocké dans la rampe commune,
une pompe à pression configurée de manière à alimenter la rampe commune en carburant à haute pression, et
une unité de contrôle d'injection configurée de manière à émettre un signal d'entraînement au dispositif d'injection.
